# EUROPEAN PATENT SPECIFICATION

(11) **EP 2 667 543 B1**
(45) Date of publication and mention of the grant of the patent: **07.01.2015**
(21) Application number: 12004030.8
(22) Date of filing: 24.05.2012
(51) Int. Cl.: H04L 12/26, H04L 12/40

(54) **Method for detecting electrical deteriorations in a bus network**
Verfahren zum Nachweis der elektrischen Verschlechterungen in einem Bus-Netzwerk
Procédé pour détecter des détériorations électriques dans un réseau de bus

(43) Date of publication of application: 27.11.2013
(73) Proprietor: Airbus Defence and Space GmbH, 85521 Ottobrunn (DE)
(72) Inventor: Schneider, Tobias, 89073 Ulm (DE)
(74) Representative: Riegel, Werner

(56) References cited:
- EP-A2- 1 150 458
- GB-A- 1 157 207

## Description

The invention relates to a Method for detecting electrical deteriorations in a bus network according to claim 1.

The current approaches for the detection of failures or electrical deterioration in data bus networks is either:
a) to de-install all connected bus users and (if necessary) load the bus with dummy load. Then execute the measurement with a signal source (e.g. Signal Generator or special measurement equipment) and a signal sink (e.g. Oscilloscope or special measurement equipment). Repeat this measurement for each data path which is under interest. After the measurement the bus users have to be re-installed and the necessary acceptance and test procedure for the exchange of equipment has to be performed.
   The disadvantages are the de-installation, installation and re-testing of the bus users and system. This leads to additional amount of time for the maintenance crew and there is still the risk that the de-installation and installation itself will produce additional errors.
b) or to use the Time Domain Reflectometry (TDR). For the TDR measurement, an impulse is transmitted into the wiring and the echo (which is produced by distortions in the impedance) is measured. The time between impulse and the reception of the echo is used to identify the position of the distortion, the value and shape of the received signal are used to identify the source of the distortion (connectors, open-end, break, short, etc.).

The disadvantages for this method is that the wiring has to be opened to connect the TDR equipment. And, this is the more important disadvantage, for transformer coupled busses (like MIL-STD-1553B, CAN, etc.) the transmission characteristics and the bandwidth limitation of the transformers significantly reduces the informational value of the TDR measurement. For MIL-STD-1553B topologies using multi stub couplers, the TDR is not able to resolve the source of the echoes (for a 2 or more stub coupler the TDR cannot distinguish whether the echo was sourced by the first, second or n-th stub).

GB 1 157 207 A describes a measuring device for determining attenuation produced by an electric network under test, comprising a calibrated attenuator having a controllable attenuation, a comparison device having an indicator, and a signal source for providing a signal to the electric network. The comparison device comprises a first and a second capacitor, a plurality of switches and a control device for the switches. The control device being used to operate the switches and the switches being arranged so that during a first time the first capacitor and the second capacitor are simultaneously charged. During the second time the voltage across the two capacitors are compared with each other, the difference voltage being applied to the indicator and finally during third time the two capacitors are discharged.

It is therefore an object of the present invention to provide a method to investigate the health status of bus network and the localisation of wiring failures or electrical bus deterioration, without removal of equipment.

This object is using the method having the features of claim 1, ie by a method for detecting electrical deteriorations in a bus network, whereby the bus network comprises at least one data path to at least one device, comprising the steps:
- performing a reference measurement at time to in a first non-recurring step of the method under undisturbed conditions on the at least one data path between a source device and the at least one sink device,
- applying a test signal to the at least one data path of the bus network under test by the source device comprising a variable attenuator and a terminal unit,
- measuring and comparing the attenuation of the at least one data path between the source device and the at least one sink device at a time later than to with a reference measurement of the attenuation of the same data path between the source device and the same sink device,
- determining the distorted data paths for which the absolute difference of the measured attenuation between the reference measurement performed at time to and the measurement performed later than t₀ is above a given threshold and
- deriving the position of the electrical deteriorations within the bus network by determining the elements, which are common for the distorted data paths but are not common with the undistorted data paths.

The advantage achieved by the invention is that it the method can be executed during build in test routines without the removal of equipment. Further the method can be included into build in test routines in existing equipment attached to the bus.

The new idea is to establish an indirect measurement of the attenuation of the data paths between the source device including the measurement unit and all other sink devices and to compare the results of the current measurement with the stored results of the past measurements. With the inclusion of the knowledge of the wiring structure, the parts of the wiring, showing signs of electrical characteristics deterioration, can be identified.

In an embodiment of the invention the measurement of the attenuation of a data path between the source and a sink device is performed in a loop, whereby the attenuation of the variable attenuator is increased gradually until no valid communication with a sink device under test in the bus network is possible.

The measured attenuator level identifies the margin which is left until no valid communication with a specific sink is possible. Advantageously the transmission protocol of the signal of the source device defines the signal level ranges for valid and invalid signals (e.g. as it is defined within MIL-STD-1553B).

The following describes the invention and embodiments of the invention with reference to the embodiments shown in the figures and explained. In the drawings:
- Fig. 1: A schematic design of a bus network connected to a source device performing the method according to the invention,
- Fig. 2: a schematic design according to fig. 1 with a source device and a bus network without electrical deteriorations,
- Fig. 3: a schematic design according to fig. 1 with a source device and a bus network with an electrical deteriorations in a main line segment,
- Fig. 4: a schematic design according to fig. 1 with a source device and a bus network with an electrical deteriorations in a distribution feeder from the main line segment to a device.

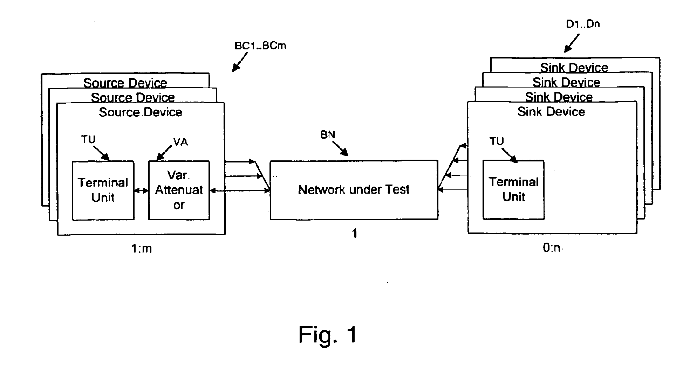

Fig.1 shows a schematic design of a bus network connected to one or more source devices. Each source device BC1,...,BCm comprises a terminal unit TU and a variable attenuator VA and the source device BC1,...,BCm is capable to take over the role of a sink device D1,...,Dn by deactivating the variable attenuator VA The source device is connected to a bus network BN under test. And one or more sink devices D1,...,Dn. Each sink device D1,...,Dn comprises a terminal unit TU.

The terminal unit is part of an equipment which allows to communicate according to the specified technology via a bus network. Normally a terminal unit TU is able to transmit and receive messages/signals.

As an example the bus network BN itself is connected to three source device BC1, BC2, BC3 (acting as source) and four sink devices D1, D2, D3, D4 (acting as sinks). The network is based on a single lane network.

According to the invention the reference measurement, which is an initial measurement, is performed in a first non-recurring step of the method under undisturbed conditions on the at least one data path between the source device and the at least one sink device. This means in other word, the reference measurement describes the condition of the bus network for the point in time to assuming that there are no electrical deteriorations in the bus network.

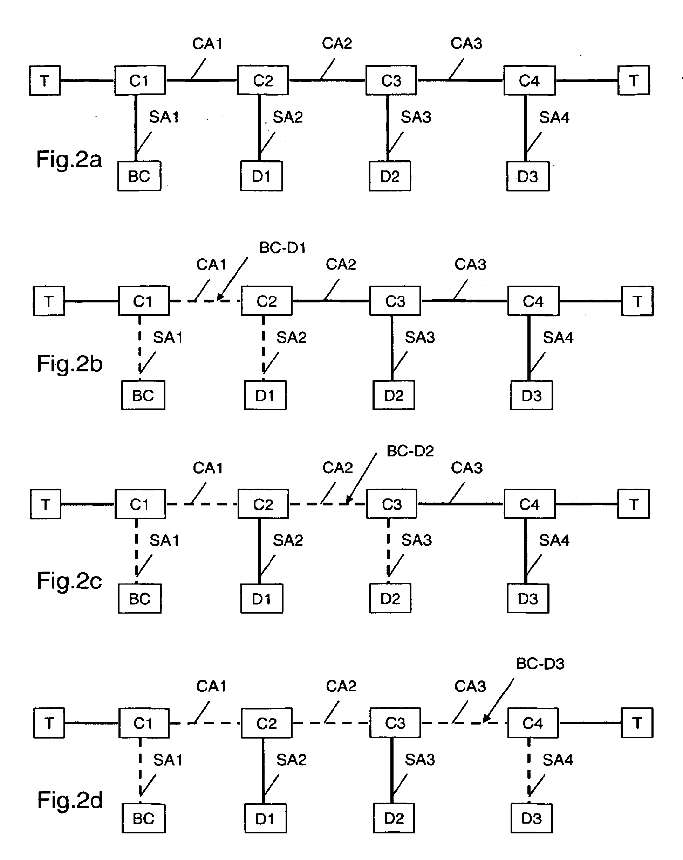

Fig. 2 to 4 explain how the measurement will be executed. The doted path in each figure indicates the path which is currently under investigation. All three exemplary data paths BC-D1, BC-D2, BC-D3 from the source device BC to the sink devices D1, D2, 3 will be examined.

Fig. 2 shows a schematic design with a bus controller and a bus network without electrical deteriorations. The bus network under test itself consist of
- The back bone or main line segment ML which ends are terminated by a terminator T,
- Stubs SA2, SA3, SA4 which are the distribution feeders from the main line ML to the sink devices D1, D2, D3
- Coupler C2, C3, C4 between main line ML and stub SA2, SA3, SA4, which can be either direct coupled or transformer coupled.

The source device BC is connected via a stub SA1 to a coupler C1 connected to the main line ML. The couplers C1, C2, C3, C4 are connected via cables CA1, CA2, CA3, CA4.

Fig. 2a shows the situation without measurement. Fig. 2b shows the situation where sink device D1 is tested. The tested path is indicated by the doted line. Fig. 2c and 2d show the situation where sink devices D2 and D3 are tested.

At the end the measurement three attenuator values (which are equivalent to the margin the bus network provides for each data path) have been determined. The following table shows exemplarily the determined values:

| Measurement Results | | D1 | D2 | D3 |
|---|---|---|---|---|
| Current Run t₀ | | -13dB | -13,3dB | -13,8dB |

This reference measurement has to be executed at the beginning of in service phase of the data bus network to determine a datum for a healthy bus topology.

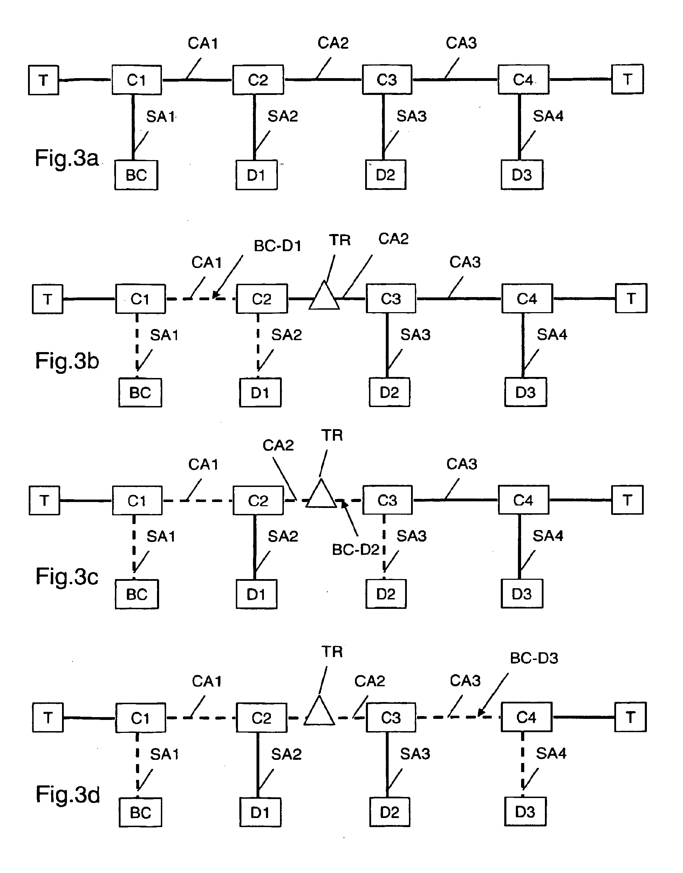

Fig. 3 shows how the process works in case of an increased attenuation (e.g. aging of contacts, deterioration of the dielectric etc.). The cable segment CA2 will have an higher attenuation level than all other segments CA1, CA3. The measurement is executed at tₙ, some time after the initial measurement t₀.

The process will loop through all data connections and measure the attenuation level until the transmission between the signal source of the bus controller and the device under test will break. And again the dotted path indicates the path on which the measurement will take place. The triangle TR indicates the position of the distortion .

The loop cycles for D2 and D3 will be affected by the distortion which will be visible in the measurement result listed in the next table.

| Measurement Results | | D1 | D2 | D3 |
|---|---|---|---|---|
| First Run t₀ | | -13dB | -13,3dB | -13,8dB |
| Current Run tₙ | | -13,1 dB | -14,1dB | -14,6dB |
| Delta | | -0,1dB | -0,8dB | -0,8dB |

The comparison between the current run and the first run will show an increase of the attenuation for the transmission paths source device BC to sink device D2 and source device BC to sink device D3. For both measurement paths BC to D2 and BC to D3 a significant increase of the attenuation was detected. Exemplary the threshold is set to absolute 0,5 dB. Therefore the detected absolute delta in the measurement path BC to D2 and BC to D3 is above the given threshold.

The level of the increase is the same for both paths, so that the source of the additional attenuation must be located in the common elements for the path BC to D2 and BC to D3, but not common with path BC to D1. The common element is Cable CA2.The combination of the past and current measurement and the knowledge of the network structure will lead to identification of the location of the distortion.

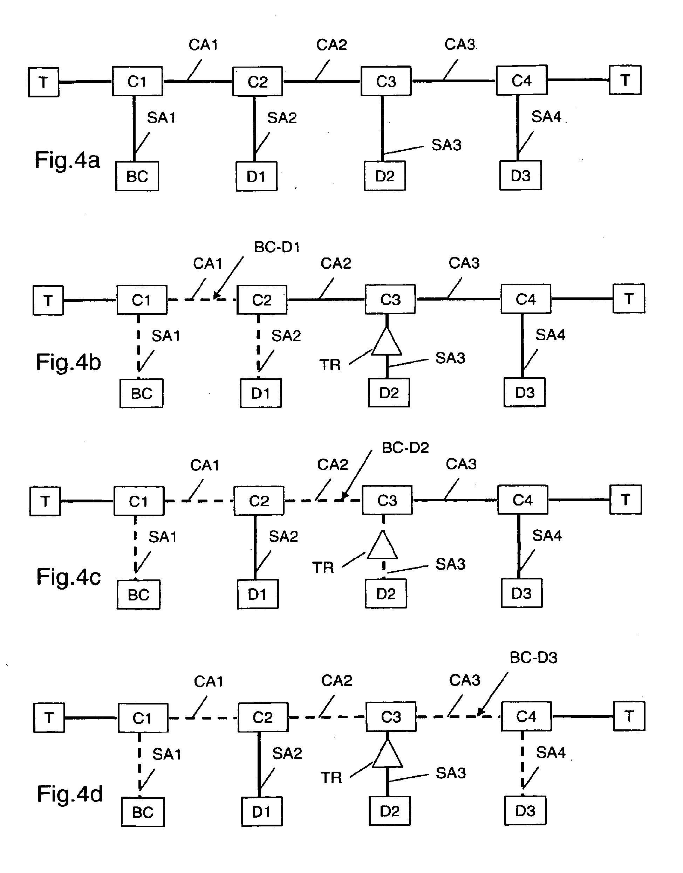

Similar to the detection of main line errors the detection of stub errors will be processed in the same way (fig. 4). For the next example the error will be located at the Stub SA3 (triangle TR) and the loops are marked with a doted line.

The loop cycle for D2 will be affected by the distortion which will be visible in the measurement result listed in the next table.

| Measurement Results | | D1 | D2 | D3 |
|---|---|---|---|---|
| First Run t₀ | | -13dB | -13,3dB | -13,8dB |
| Current Run tₙ | | -13,1dB | -14,1dB | -13,9dB |
| Delta | | -0,1dB | -0,8dB | -0,1dB |

As expected only the measurement covering the Stub SA3(erroneous stub) will have the higher attenuation and this was the measurement in the path source device BC to sink device D2. No other paths are affected.

## Claims

1. Method for detecting electrical deteriorations in a bus network (BN), whereby the bus network (BN) comprises at least one data path (BC1-D1, BC1-D2, BC1-D3, ..., BCm-Dn) to at least one sink device (D1, ... Dn ),
**characterised in**
performing a reference measurement at time to in a first non-recurring step of the method under undisturbed conditions on the at least one data path (BC1-D1, BC1-D2, BC1-D3, ..., BCm-Dn) between a source device (BC1,...,BCm) and the at least one sink device (D1, ... Dn),
applying a test signal to the at least one data path (BC1-D1, BC1-D2, BC1-D3, ...,BCm-Dn) of the bus network (BN) under test by the source device (BC1,...,BCm) comprising a variable attenuator (VA) and a terminal unit (TU),
measuring and comparing the attenuation of the at least one data path (BC1-D1, BC1-D2, BC1-D3, ..., BCm-Dn) between the source device (BC1,...,BCm) and the at least one sink device (D1,..., Dn) at a time later than to with a reference measurement of the attenuation of the same data path (BC1-D1, BC1-D2, BC1-D3, ..., BCm-Dn) between the source device (BC1,...,BCm) and the same sink device (D1,...,Dn),
determining the distorted data paths for which the absolute difference of the measured attenuation between the reference measurement performed at time to and the measurement performed later than to is above a given threshold and
deriving the position of the electrical deteriorations within the bus network (BN) by determining the elements, which are common for the distorted data paths but are not common with the undistorted data paths.

2. Method according to claim 1,
**characterised in that**
the measurement of the attenuation of one or more data pathes (BC1-D1, BC1-D2, BC1-D3, ..., BCm-Dn) between the source device (BC) and a sink device (D1,... Dn) is performed in a loop, whereby the attenuation of the variable attenuator is increased gradually until no valid communication with a device under test in the bus network (BN) is possible.

## Patentansprüche

1. Verfahren zum Detektieren elektrischer Verschlechterungen in einem Busnetzwerk (BN), wobei das Busnetzwerk (BN) mindestens einen Datenpfad (BC1-D1, BC1-D2, BC1-D3, ..., BCm-Dn) zu mindestens einer Senkenvorrichtung (D1, ..., Dn) umfasst,
**gekennzeichnet durch**
Durchführen einer Referenzmessung zur Zeit t₀ in einem ersten nichtwiederholenden Schritt des Verfahrens unter ungestörten Bedingungen auf dem mindestens einen Datenpfad (BC1-D1, BC1-D2, BC1-D3, ..., BCm-Dn) zwischen einer Quellenvorrichtung (BC1, ..., BCm) und der mindestens einen Senkenvorrichtung (D1, ..., Dn),
Anlegen eines Testsignals an den mindestens einen Datenpfad (BC1-D1, BC1-D2, BC1-D3, ..., BCm-Dn) des zu testenden Busnetzwerks (BN) **durch** die Quellenvorrichtung (BC1, ..., BCm), die einen variablen Abschwächer (VA) und eine Abschlusseinheit (TU) umfasst,
Messen und Vergleichen der Abschwächung des mindestens einen Datenpfads (BC1-D1, BC1-D2, BC1-D3, ..., BCm-Dn) zwischen der Quellenvorrichtung (BC1, ..., BCm) und der mindestens einen Senkenvorrichtung (D1, ..., Dn) zu einer Zeit später als t₀ mit einer Referenzmessung der Abschwächung desselben Datenpfads (BC1-D1, BC1-D2, BC1-D3, ..., BCm-Dn) zwischen der Quellenvorrichtung (BC1, ..., BCm) und derselben Senkenvorrichtung (D1, ..., Dn),
Bestimmen der verzerrten Datenpfade, für die die absolute Differenz der gemessenen Abschwächung zwischen der zur Zeit t₀ durchgeführten Referenzmessung und der später als t₀ durchgeführten Messung über einer gegebenen Schwelle liegt und
Ableiten der Position der elektrischen Verschlechterungen innerhalb des Busnetzwerks (BN) durch Bestimmen der Elemente, die den verzerrten Datenpfaden gemein sind, aber nicht den unverzerrten Datenpfaden gemein.

2. Verfahren nach Anspruch 1,
**dadurch gekennzeichnet, dass**
die Messung der Abschwächung eines oder mehrerer Datenpfade (BC1-D1, BC1-D2, BC1-D3, ..., BCm-Dn) zwischen der Quellenvorrichtung (BC) und einer Senkenvorrichtung (D1, ..., Dn) in einer Schleife durchgeführt wird, wodurch die Abschwächung des variablen Abschwächers graduell erhöht wird, bis keine gültige Kommunikation mit einer zu testenden Vorrichtung in dem Busnetzwerk (BN) mehr möglich ist.

## Revendications

1. Procédé pour détecter des détériorations électriques dans un réseau en bus (BN), le réseau en bus (BN) comprenant au moins un chemin de données (BC1-D1, BC1-D2, BC1-D3, ..., BCm-Dn) vers au moins un dispositif collecteur (D1, ..., Dn),
**caractérisé en ce qu'**il consiste à
effectuer une mesure de référence à un instant t₀ à une première étape non récurrente du procédé dans des conditions non perturbées sur ledit au moins un chemin de données (BC1-D1, BC1-D2, BC1-D3, ..., BCm-Dn) entre un dispositif source (BC1, ..., BCm) et ledit au moins un dispositif collecteur (D1, ..., Dn),
appliquer un signal-test audit au moins un chemin de données (BC1-D1, BC1-D2, BC1-D3, ..., BCm-Dn) du réseau en bus (BN) sous test par le dispositif source (BC1, ..., BCm) comprenant un atténuateur variable (VA) et une unité terminale (TU),
mesurer l'atténuation dudit au moins un chemin de données (BC1-D1, BC1-D2, BC1-D3, ..., BCm-Dn) entre le dispositif source (BC1, ..., BCm) et ledit au moins un dispositif collecteur (D1, ..., Dn) à un instant ultérieur à t₀ et la comparer à une mesure de référence de l'atténuation du même chemin de données (BC1-D1, BC1-D2, BC1-D3, ..., BCm-Dn) entre le dispositif source (BC1, ..., BCm) et le même dispositif collecteur (D1, ..., Dn),
établir les chemins de données présentant une distorsion pour lesquels la différence absolue de l'atténuation mesurée entre la mesure de référence effectuée à l'instant t₀ et la mesure effectue ultérieurement à t₀ est supérieure à un seuil donné, et
déduire la position des détériorations électriques au sein du réseau en bus (BN) en établissant les éléments qui sont communs pour les chemins de données présentant une distorsion mais qui ne sont pas communs avec les chemins de données sans distorsion.

2. Procédé selon la revendication 1,
**caractérisé en ce que**
la mesure de l'atténuation d'un ou de plusieurs chemins de données (BC1-D1, BC1-D2, BC1-D3, ..., BCm-Dn) entre le dispositif source (BC) et un dispositif collecteur (D1, ..., Dn) est effectuée dans une boucle, l'atténuation de l'atténuateur variable étant augmentée progressivement jusqu'à rendre impossible toute communication valide avec un dispositif sous test dans le réseau en bus (BN).
